# EUROPEAN PATENT APPLICATION

(11) **EP 4 749 589 A1**
(43) Date of publication of application: **27.05.2026**
(21) Application number: 25217610.2
(22) Date of filing: 21.11.2025
(51) Int. Cl.: G06V 30/414, G06V 30/422, G06V 10/82

(54) **METHOD, APPARATUS, DEVICE, AND STORAGE MEDIUM FOR RECOGNIZING ELECTRICAL ELEMENT**

(30) Priority: 22.11.2024 CN 202411686727
(71) Applicant: Schneider Electric (China) Co., Ltd., Beijing 100102 (CN)
(72) Inventor: HU, Guang, Shanghai, 201203 (CN); HEI, Minglei, Shanghai, 201203 (CN); LIU, Zhiyuan, Shanghai, 201203 (CN); WANG, Zhichong, Shanghai, 201203 (CN); YANG, Shaomin, Shanghai, 201203 (CN)
(74) Representative: Openshaw & Co.

(57) **Abstract**

A method (200), an apparatus (500), a device (600), and a storage medium for recognizing an electrical element are provided. In the method (200), graphic data of a graphic file to be recognized is obtained. The graphic file indicates a layout of electrical elements of an electrical system, and the graphic data includes respective data indicating a plurality of graphic entities of the layout of electrical elements. One or more block graphic entities are recognized from the graphic data based on the respective data of the plurality of graphic entities. Based on respective data of the one or more block graphic entities, one or more first electrical elements of the electrical system respectively corresponding to the one or more block graphic entities and respective first locations of the one or more first electrical elements in the electrical system are determined.

## Description

### FIELD

Embodiments of the present disclosure generally relate to the field of computers, and in particular, to a method, an apparatus, a device, and a storage medium for recognizing an electrical element.

### BACKGROUND

A single line diagram is a two-dimensional topological graph of electrical connection paths from a power source to various loads in a power distribution system and is an indispensable design and maintenance tool in the power distribution industry. However, since these diagrams are usually drawn by different design institutes or designers, their layouts and symbol styles vary widely, and may not strictly follow unified industry standards, resulting in great challenges in interpreting drawings. Traditionally, when recognizing electrical elements in the single line diagram, a bill of materials is generated by manually recognizing the single line diagram, which is inefficient and error-prone.

### SUMMARY

In a first aspect of the present disclosure, a method for recognizing an electrical element is provided. The method for recognizing the electrical element includes: obtaining graphic data of a graphic file to be recognized, the graphic file indicating a layout of electrical elements of an electrical system, and the graphic data including respective data indicating a plurality of graphic entities of the layout of electrical elements; recognizing one or more block graphic entities from the graphic data based on the respective data of the plurality of graphic entities; and determining, based on respective data of the one or more block graphic entities, one or more first electrical elements of the electrical system respectively corresponding to the one or more block graphic entities and respective first locations of the one or more first electrical elements in the electrical system.

In a second aspect of the present disclosure, an apparatus for recognizing an electrical element is provided. The apparatus for recognizing the electrical element includes: an obtaining module configured to obtain graphic data of a graphic file to be recognized, the graphic file indicating a layout of electrical elements of an electrical system, and the graphic data including respective data indicating a plurality of graphic entities of the layout of electric elements; a recognition module configured to recognize one or more block graphic entities from the graphic data based on the respective data of the plurality of graphic entities; and a determination module configured to determine, based on the respective data of the one or more block graphic entities, one or more first electrical elements of the electrical system respectively corresponding to the one or more block graphic entities and respective first locations of the one or more first electrical elements in the electrical system.

In a third aspect of the present disclosure, an electronic device is provided. The electronic device includes: at least one processing unit; and at least one memory coupled to the at least one processing unit and storing instructions for execution by the at least one processing unit. The instructions, when executed by the at least one processing unit, cause the electronic device to perform the method according to the first aspect of the present disclosure.

In a fourth aspect of the present disclosure, there is provided a computer-readable storage medium having a computer program stored thereon. The computer program, when executed by a processor, causes the processor to implement the method according to the first aspect of the present disclosure.

In a fifth aspect of the present disclosure, there is provided a computer program product, including a computer program. The computer program, when executed by a processor, implements the method according to the first aspect of the present disclosure.

It will be appreciated from the following description that in the process of recognizing an electrical element in a graphic file, one or more block graphic entities may be recognized from graphic data based on respective data of a plurality of graphic entities, according to an embodiment of the present disclosure. Next, one or more first electrical elements of the electrical system respectively corresponding to the one or more block graphic entities and respective first locations of the one or more first electrical elements in the electrical system may be determined based on respective data of the one or more block graphic entities. In this way, the electrical element and the location where the electrical element is located can be recognized in the graphic file without analyzing geometric features of the electrical element, thereby improving the accuracy of recognition of the electrical element and the recognition efficiency. Other benefits will be described below in connection with corresponding embodiments.

It should be understood that the content described in this content section is not intended to limit the key features or important features of the embodiments of the present disclosure, nor is it intended to limit the scope of the present disclosure. Other features of the present disclosure will become readily understood from the following description.

### BRIEF DESCRIPTION OF DRAWINGS

The above and other features, advantages, and aspects of various embodiments of the present disclosure will become more apparent from the following detailed description taken in conjunction with the accompanying drawings. In the drawings, the same or similar reference numbers refer to the same or similar elements. In the drawings:
FIG. 1 illustrates a schematic diagram of an example environment in which embodiments of the present disclosure may be implemented;
FIG. 2 illustrates a flowchart of an example process of recognizing an electrical element according to some embodiments of the present disclosure;
FIG. 3 illustrates a schematic diagram of recognizing one or more block graphic entities from graphic data according to some embodiments of the present disclosure;
FIG. 4A illustrates a schematic diagram of graphic data of a graphic file including a plurality of graphic entities according to some embodiments of the present disclosure;
FIG. 4B illustrates a schematic diagram of recognizing a block graphic entity in graphic data of a graphic file according to some embodiments of the present disclosure;
FIG. 4C illustrates a schematic diagram of a graphic entity other than a block graphic entity in graphic data of a graphic file according to some embodiments of the present disclosure;
FIG. 5 illustrates a block diagram of an apparatus for recognizing an electronic component according to some implementations of the present disclosure; and
FIG. 6 illustrates a block diagram of a device in which various implementations of the present disclosure may be implemented.

### DETAILED DESCRIPTION

Embodiments of the present disclosure will be described in more detail below with reference to the accompanying drawings. While certain embodiments of the present disclosure are shown in the drawings, it is to be understood that the present disclosure may be implemented in various forms and should not be construed as being limited to the embodiments set forth herein, but rather, these embodiments are provided for a more thorough and complete understanding of the present disclosure. It should be understood that the drawings and embodiments of the present disclosure are for illustrative purposes only and are not intended to limit the protection scope of the present disclosure.

In the description of the embodiments of the present disclosure, the terms "including" and the like should be understood as an open-ended inclusion, i.e., "including but not limited to". The term "based on" should be understood as "based at least in part on". The terms "one embodiment" or "the embodiment" should be understood as "at least one embodiment". The terms "first", "second", and the like may refer to different or identical objects. Other explicit and implicit definitions may also be included below.

### Example Environment

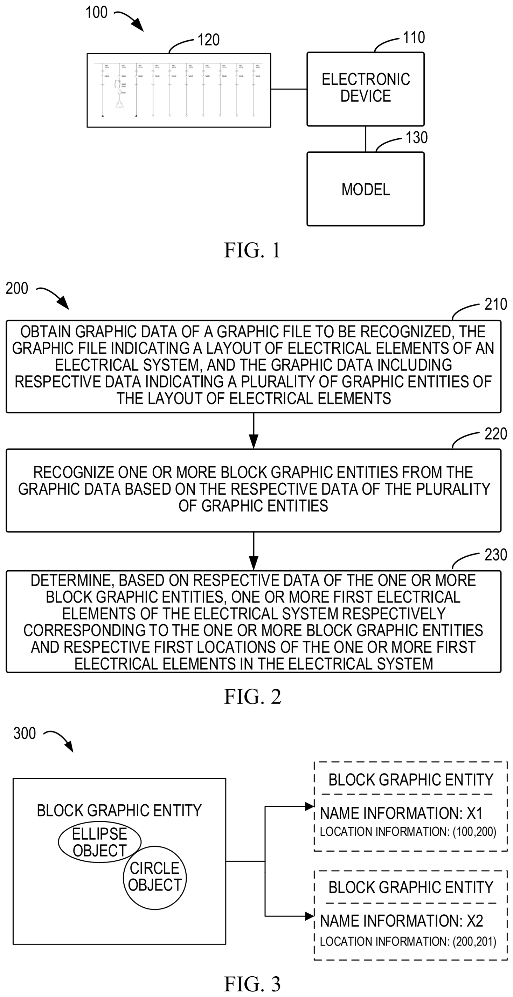

FIG. 1 illustrates a schematic diagram of an example environment 100 in which embodiments of the present disclosure may be implemented. The example environment 100 may generally include an electronic device 110.

The electronic device 110 may obtain graphic data related to a graphic file 120 of the electrical system to be processed, such as graphic data of a single line diagram of the electrical system. The graphic file 120 may be configured to indicate a layout of electrical elements of any suitable type of electrical system or a part thereof. In addition to various electrical elements, the graphic file 120 also includes connection lines for representing how these elements are electrically coupled together. The electronic device 110 may analyze a name and location of the electrical elements, the number of electrical elements, connection relationships among electrical elements, and other relevant information based on the obtained graphic data related to the graphic files 120 of the electrical system.

In the example environment 100, the electronic device 110 may be any type of device having computing capability, including a terminal device or a server device. The terminal device may be any type of mobile terminal, fixed terminal, or portable terminal, including a mobile phone, a desktop computer, a laptop computer, a notebook computer, a netbook computer, a tablet computer, a media computer, a multimedia tablet, a personal communication system (PCS) device, a personal navigation device, a personal digital assistant (PDA), an audio/video player, a digital camera/camcorder, a positioning device, a television receiver, a radio broadcast receiver, an e-book device, a gaming device, or any combination of the foregoing, including accessories and peripherals of these devices, or any combination thereof. The server device may include, for example, a computing system/server, such as a mainframe, an edge computing node, a computing device in a cloud environment, or the like.

Alternatively and/or additionally, a machine learning model (e.g., a model 130) may be provided to assist in recognizing electrical elements in a graphic file. It should be understood that although FIG. 1 illustrates that the model 130 is located outside the electronic device 110, alternatively and/or additionally, the model 130 may also be integrated within the electronic device 110, and the electronic device 110 or other device may access the model 130 via a network or a data line.

The model 130 may include one or more models. If the model 130 includes a plurality of models, the plurality of models may include a plurality of types of models. The model 130 may include, for example, at least an image recognition model and a deep learning model. The image recognition model is trained by a large number of annotated image data, and model parameters are adjusted by using a backpropagation algorithm to minimize difference between a predicted label and a real label. After the training is completed, a new unannotated image is input into the model, and the model outputs a classification result of the image or a detected object location and category. The deep learning model is trained through a large number of labeled data, and the model parameters are iteratively updated by using an optimization algorithm such as gradient descent so as to minimize the loss function, thereby improving the prediction accuracy of the model. After the training is completed, a new input data (such as text or the like) is input into the model, and the model outputs a corresponding prediction result (for example, a classification label, a detection box, etc.).

It should be understood that the structure and function of the environment 100 is described for illustrative purposes only and does not imply any limitation to the scope of the present disclosure. The single line diagram of the electrical system and its graphic shown in FIG. 1 are illustrative only and are not intended to limit the scope of the present disclosure.

As mentioned above, since graphic files of the electrical systems are usually drawn by different design institutes or designers, their layouts and symbol styles vary widely, and may not strictly follow unified industry standards, resulting in great challenges in interpreting drawings.

There are a number of deficiencies in a method for generating a bill of materials by manually recognizing a single line diagram. Manual recognition depends on professional knowledge and personal experience of an operator, and thus a bias in subjective judgment may occur in the recognition process, resulting in an inaccurate recognition result. In addition, the manual recognition process usually needs to check each element on the drawing one by one, and manually record information such as the type(s), the specification, and the quantity of elements, and when confronted with a complex and bulky electrical system, the workload increases exponentially, thereby significantly reducing the working efficiency.

In order to improve the efficiency issue of manual recognition, there is also an automated recognition method based on geometric features to analyze shape features of the electrical elements to distinguish different element types, for example, classifying them based on whether an outline of the element has a geometric attribute such as a circle, a rectangle, a triangle, or the like. Although this method has improved the recognition speed to a certain extent, due to the fact that the shape design of the electrical element tends to have a large similarity, it is difficult to accurately distinguish different types of elements depending on geometrical features. For example, a resistor, an inductor, and even certain types of switches may appear very similar in a single line diagram, e.g., all are simple rectangles or rectangular boxes, thus posing a challenge for automated recognition. In addition, in practical applications, it is also often encountered that elements in the single line diagram may not be drawn strictly according to standard symbols, and may be deformed or simplified, which further increases the difficulty of the geometric feature recognition method. In addition, factors such as the placement angle, the location, and the mutual shielding of electrical elements in the circuit diagram may affect the effect of a recognition algorithm, thereby leading to the phenomen that a large number of erroneous judgments and missing judgments may occur in the finally generated bill of materials.

As mentioned above, as the number, type and connection relationship of electrical elements in an electrical system are increasingly complex, how to improve the recognition efficiency and accuracy of electrical elements has become one of the urgent issues to be addressed.

### Example Process

FIG. 2 illustrates a flowchart of an example process 200 of recognizing an electrical element according to some embodiments of the present disclosure. In some embodiments, the process 200 may be performed by the electronic device 110 as shown in FIG. 1. It should be understood that the process 200 may also include additional blocks not shown and/or one (or more) of the illustrated blocks may be omitted, and the scope of the present disclose is not limited in this regard.

At block 210, the electronic device 110 first needs to obtain graphic data of a graphic file to be recognized. The graphic files to be recognized are configured to indicate a layout of electrical elements of an electrical system, and the graphic data includes respective data indicating a plurality of graphic entities of the layout of electrical elements. As an example, the graphic file may be a DWG, DXF formatted graphic file for a computer aided design (CAD) software to read. These files may accurately represent complex graphic information.

For example, a single line diagram may present a layout and a connection mode of electrical elements (e.g., a circuit breaker, a transformer, a cable, etc.) in a substation, a power distribution system, or other electrical facility. Through these graphic files, engineers and technicians can clearly understand the structure and working principle of the system, thereby performing operations such as design, maintenance and troubleshooting.

As an example, the graphic data may include coordinate data, for example, point coordinates, a center coordinate, control point coordinates, etc. The point coordinates are used to indicate coordinates of a starting point and an ending point of each graphic entity, such as a starting point and an ending point coordinate of a straight line. The center coordinate may be, for example, a center point coordinate of a shape such as a circle or an ellipse. The control point coordinates are used to define control point coordinates of a curve, such as a spline curve.

As another example, the graphic data may include entity names, labels, and the like. The entity name is used to indicate a name of each graphic entity, such as "circuit breaker 1", "transformer 2", etc. The label is a text label attached to the graphic entity for annotating information such as a model, a specification and a serial number of the element.

As yet another example, the graphic data may include visibility attributes, colors, line types, line widths, etc. of the graphic entities. The visibility attribute of the graphic entity indicates whether the graphic entity is presented on a display interface. The color of the graphic entity is used to distinguish between different types of elements or connection lines.

It should be understood that the graphic data may further include a layer name to which each graphic entity belongs, a visibility of the layer, a locking status, a geometric attribute, and annotation information attached to the graphic file, etc., which is not intended to be limited in the present disclosure.

In the process of obtaining the graphic data of the graphic file to be recognized, the electronic device 110 may obtain one or more of the graphic data as needed. By obtaining and parsing these graphic data, the electronic device 110 may comprehensively understand the layout and connection relationship of the electrical system.

At block 220, the electronic device 110 needs to recognize one or more block graphic entities from respective graphic data of the plurality of graphic entities. The block graphic entity may include a plurality of basic graphic entities, such as straight lines, circles, arcs, and the like. By recognizing the block graphic entity, management and processing of the graphic data can be simplified, thereby improving the analysis efficiency.

As shown in FIG. 3, the electronic device 110 may parse the graphic data in the graphic file, and extract detailed information of each graphic entity, including coordinates, a name, a visibility attribute, a layer, and the like. In the graphic data, the block graphic entity generally has a unique name for recognizing the block. The electronic device 110 may find all defined blocks by searching for block definition information in the graph data. Each block defines information such as the origin of the block, a graphic entity within the block, and its relative coordinate.

As an example, the single line diagram of the electrical system may include a plurality of block graphic entities, such as blocks representing a circuit breaker, a transformer, and a cable. Each block has a unique name, such as "circuit breaker 1", "transformer 2", or the like. The electronic device 110 may extract name information of all graphic entities from the graphic file, thereby finding all defined blocks, such as "circuit breaker 1", "transformer 2", and the like.

At block 230, the electronic device 110 determines, based on respective data of the one or more block graphic entities that have been recognized, one or more first electrical elements of the electrical system respectively corresponding to the block graphic entities and respective first locations of the one or more first electrical elements in the electrical system.

The electronic device 110 may determine electrical elements represented by graphic entities according to these graphic entities and their attributes within the block graphic entities. For example, one block graphic entity may include a graphic entity representing a circuit breaker, and another block may contain a graphic entity representing a transformer. A name, a type, and an attribute of each electrical element may be obtained from a label of the graphic entity and a block definition.

In addition, the electronic device 110 may calculate absolute coordinates of the graphic entity in the block in the design according to an insertion point, a proportion, and a rotation angle of a block reference. These absolute coordinates represent the actual location of the electrical element in the electrical system. By calculating the obtained absolute coordinates, the electronic device 110 may determine a first location of each electrical element in the electrical system.

As an example, the electronic device 110 may determine electrical elements represented by these block graphic entities, e.g., "circuit breaker 1" represents a circuit breaker, and "transformer 2" represents a transformer. Then, the electronic device 110 may calculate the absolute coordinates of the graphic entity in the block in the graphic file according to the insertion point, the proportion and the rotation angle of the block reference. For example, absolute coordinates of the circuit breaker 1 may be (100, 200) and absolute coordinates of the transformer 2 may be (300, 400). By calculating the obtained absolute coordinates, the electronic device 110 may determine a first location of each electrical element in the electrical system.

In this way, in the process of recognizing the electrical element in the graphic file, the electronic device 110 may recognize the electrical element and the location where the electrical element is located in the graphic file without analyzing the geometric feature of the electrical element, thereby improving the accuracy of recognition of the electrical element and the recognition efficiency.

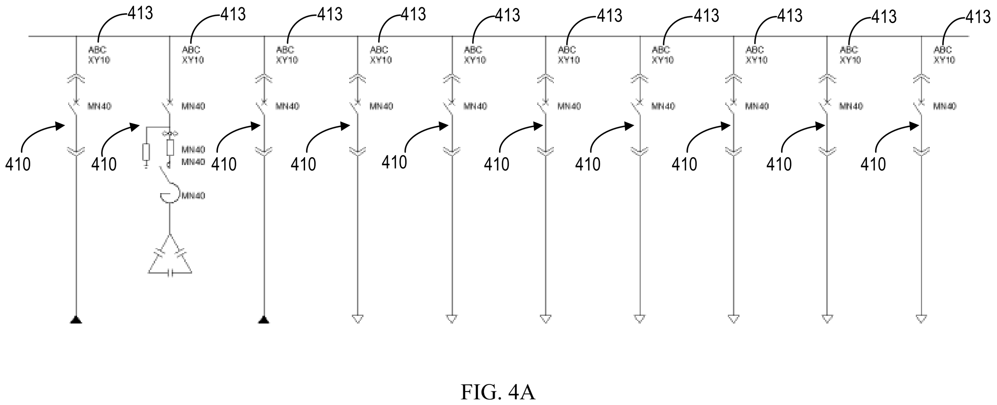

A summary according to some implementations of the present disclosure has been described above. Further details regarding recognizing an electronic element are described below with reference to FIGS. 4A-4C. It should be understood that an example process of recognizing the electrical element based on the read graphic data is described with reference to FIGS. 4A-4C, rather than direct processing of a graphic file (e.g., a drawing).

As shown in FIG. 4A, graphic data of a graphic file may indicate a plurality of graphic entities 410. The plurality of graphic entities 410 include not only respective data for one or more block graphic entities 411, but also respective data for other types of graphic entities 412. For example, the block graphic entity is referred to as a first-type graphic entity, and a graphic entity of a further type may be referred to as a second-type graphic entity 412. The second-type graphic entity may also include one or more second electrical elements that are not stored in the graphic data in the form of the block graphic entity 410 due to special structure or less use.

In order to comprehensively analyze and process these graphic data, the electronic device 110 not only recognizes the block graphic entity 411 and its corresponding electrical element and location thereof, but also recognizes electrical elements corresponding to other graphic entities and their locations.

In some embodiments, the electronic device 110 may obtain graphic data in a graphic file and extract related data of all second-type graphic entities 412. The graphic data of each of the second-type graphic entities may also include coordinates, a name, a visibility attribute, a layer, and the like. Based on the extracted data of the second-type graphic entity 412, the electronic device 110 may generate a first image. The first image is used to present a layout and connection relationship of the second-type graphic entities 412 in the electrical system.

As an example, each second-type graphic entity may be drawn in the first image according to the coordinates, the name, the visibility attribute, and the layer information of the second-type graphic entity. In the process of drawing the first image, attributes such as resolution, background color, and border of the image may be set to ensure clarity and readability of the first image. Next, the electronic device 110 saves the generated image as a common image format, such as PNG, JPEG, etc., for subsequent processing and analysis.

Next, the electronic device 110 loads a pre-trained entity recognition model 130, for example, an entity recognition model 130 based on a real-time target detection algorithm (for example, YOLO). The model 130 is trained by a large number of annotated image data to recognize and classify electrical elements in the image. The generated first image is input into the entity recognition model 130. The model 130 processes the image, extracts features from the first image, and performs classification and positioning.

As an example, the entity recognition model 130 may recognize one or more second electrical elements according to the features in the first image. The entity recognition model 130 may not only recognize a category of the second electrical element, but also the location of each second electrical element in the image. The location of the second electrical element is generally represented in the form of a bounding box, including coordinates of an upper left corner and a lower right corner. The electronic device 110 may calculate an actual location of the second electrical element in the electrical system according to the coordinates of the bounding box.

As an example, the electronic device 110 may draw a layout of the circuit breaker, the transformer, and the connection line based on the extracted graphic data of the second-type graphic entity 412. After the resolution and background color of the image are set, the image file in the PNG format is saved. Next, the electronic device 110 loads the image recognition model. The generated first image is input into the entity recognition model 130. The model 130 processes the first image, extracts features from the image, and performs classification and positioning. Next, the entity recognition model 130 may recognize a circuit breaker, a transformer, etc. in the image.

Next, the entity recognition model 130 may determine a location of each second electrical element in the image. For example, coordinates of the bounding box of an independent circuit breaker may be (150, 250) to (200, 300), and coordinates of the bounding box of the transformer may be (350, 450) to (400, 500). The electronic device 110 calculates the actual location of the electrical element in the electrical system according to the coordinates of the bounding box. For example, a second location of the independent circuit breaker in the electrical system is (150, 250) and a second location of the transformer is (350, 450). In this way, the electronic device 110 may provide a comprehensive analysis of a layout of electrical systems and connection relationships.

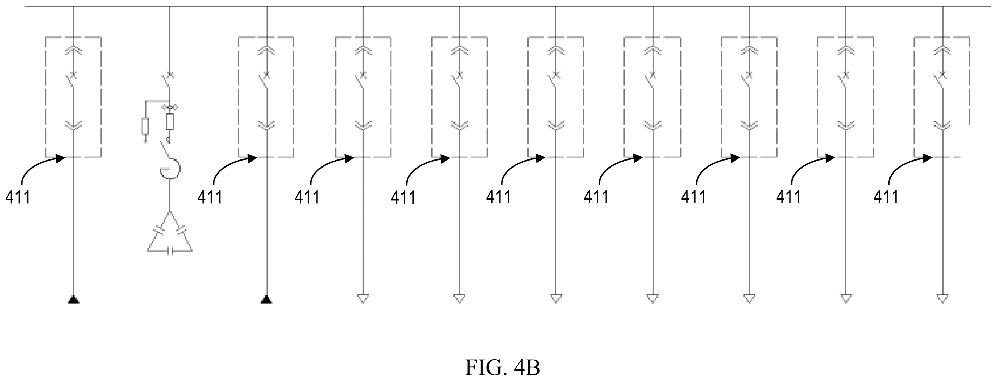

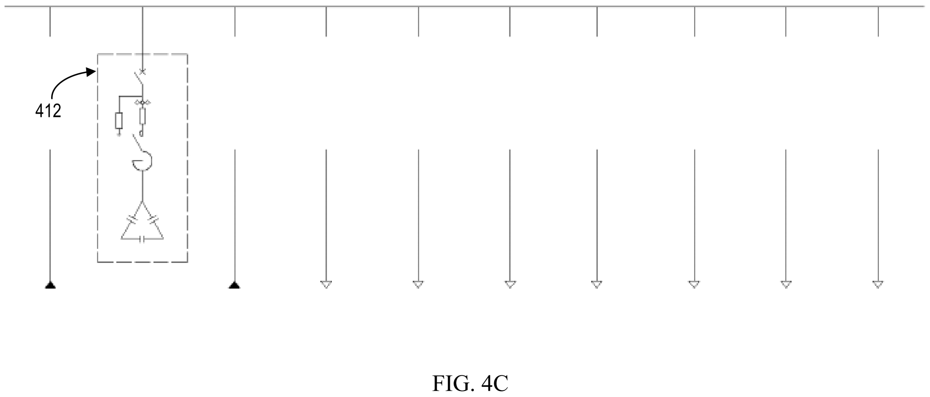

In some embodiments, as shown in FIGS. 4A, 4B, and 4C, before generating the first image, the electronic device 110 may mark a visibility attribute of respective data of the one or more block graphic entities as invisible. Next, a first image is generated based on remaining visibility data in the graphic data. In this way, in the process of generating the first image, the first electrical element corresponding to the block graphic entity does not appear on the first image. The first image is more concise, facilitating subsequent analysis and processing. Moreover, when the model 130 processes the first image, it is not necessary to consider those complex block graphic entities, but rather focuses on recognizing and analyzing the second-type graphic entities. Here, not only can the image processing process be simplified, but also the accuracy and reliability of image recognition are ensured.

In some embodiments, as shown in FIG. 4A, the graphic data further includes text annotation data for annotating information such as a name, a model number, a serial number, and the like of the electrical element. In order to improve the efficiency and accuracy of image recognition, before generating the first image, the electronic device 110 may mark a visibility attribute of the text annotation data as invisible. As shown in FIG. 4B and FIG. 4C, the text annotation information is hidden. In this way, the text annotation information and the block graphic entity are not displayed on the first image, and only the second electrical element is presented, avoiding interference to the process of the model recognizing the second electrical element in the image, and improving the efficiency and accuracy of recognizing the second electrical element.

In some embodiments, the electronic device 110 may further generate a bill of materials of the electrical system based on the recognized electrical element and its location. For example, a block graphic entity may contain a graphic entity representing a circuit breaker, named "CB-1234", with a location of (100, 200). For each first electrical element, the electronic device 110 may generate a material item based on first name information and first location of the first electrical element. In addition, for each second electrical element, the electronic device 110 may also generate a further material item based on second name information and second location of the second electrical element.

As an example, the material item may include, for example, an element name: e.g., "CB-1234" and an element location: e.g., "(100, 200)".

The electronic device 110 integrates the material item generated based on the first electrical element and the material item generated based on the second electrical element together to form a complete bill of materials. Here, the bill of materials contains names, locations, quantities, and other relevant information for all electrical elements in the electrical system. Finally, the electronic device 110 may export the integrated material items into a structured file format, such as CSV, Excel, etc., to facilitate subsequent purchase, installation and maintenance work. In this way, the information of all electrical elements in the electrical system can be comprehensively and accurately recorded.

In some embodiments, electrical image samples from multiple sources may be collected to train the entity recognition model 130. Each image sample includes not only one or more graphic entities but also annotation information of these graphic entities attached. The annotation information may include, for example, names, specifications, locations, and the like, of electrical elements (e.g., a circuit breaker, a relay, a switch, etc.). For example, on an image sample containing a plurality of electrical elements, each electrical element is marked and specific information is noted. Here, the detailed annotation information not only helps the model learn how to distinguish the target object from the background, but also allows the model to learn subtle differences between different elements, such as relays of the same type but having different specifications.

Next, the entity recognition model is trained by using the plurality of prepared image samples. As the training deepens, even though these elements may exhibit different layouts and symbolic styles on different graphic files, the model may learn subtle differences between electrical elements in the image. For example, some design institutes may prefer to use a particular symbol to represent a circuit breaker, while others may employ completely different symbols, and a fully-trained model may recognize and correctly classify these different styles of circuit breakers.

In some embodiments, in order to further improve the accuracy of the entity recognition model, a continuous training and optimization method may be adopted. For example, after the electronic device 110 generates the first image and recognizes the one or more second electrical elements using the entity recognition model, a region corresponding to each second electrical element in the first image may be separately stored as a second image, thereby forming a set of second images. The set of second images includes a large number of pictures and annotation data, which may be used to further train and update the entity recognition model. In this way, the model may continuously learn more diverse electrical element features and layout styles, thereby improving its recognition accuracy in practical applications.

As an example, if a transformer whose model is "TR-5678" is recognized in the first image and is located at (300, 400), a region where the transformer is located is cropped and stored as a single second image. All the saved second images are aggregated to form a set of second images. The set of second images includes a large amount of annotation data, and each second image carries explicit annotation information, such as an element name and a location. The existing entity recognition model is further trained and updated by using the set of second images.

### Example Apparatus and Device

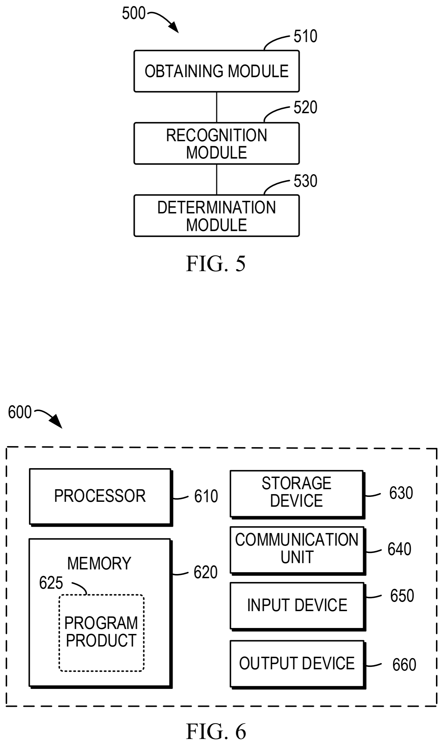

FIG. 5 illustrates a block diagram of an apparatus 500 for recognizing an electrical element according to some implementations of the present disclosure. The apparatus 500 includes an obtaining module 510 configured to obtain graphic data of a graphic file to be recognized, the graphic file indicating a layout of electrical elements of an electrical system, and the graphic data including respective data indicating a plurality of graphic entities of the layout of electrical elements; a recognition module 520 configured to recognize one or more block graphic entities from the graphic data based on the respective data of the plurality of graphic entities; and a determination module 530 configured to determine, based on the respective data of the one or more block graphic entities, one or more first electrical elements of the electrical system respectively corresponding to the one or more block graphic entities and respective first locations of the one or more first electrical elements in the electrical system.

According to some implementations of the present disclosure, the determination module 530 is further configured to: generate a first image based on data, in the graphic data, other than respective data of the one or more block graphic entities; and determine, based on the first image, one or more second electrical elements of the electrical system and respective second locations of the one or more second electrical elements in the electrical system by using the entity recognition model.

According to some implementations of the present disclosure, the graphic data further includes text annotation data, and the determination module 530 is further configured to: mark a visibility attribute of the text annotation data as invisible before generating the first image.

According to some implementations of the present disclosure, the determination module 530 is further configured to generate a bill of materials for the electrical system based at least on respective first name information and the respective first locations of the one or more first electrical elements.

According to some implementations of the present disclosure, the determination module 530 is further configured to: mark a visibility attribute of the respective data of the one or more block graphic entities as invisible; and generate the first image based on remaining visible data in the graphic data.

According to some implementations of the present disclosure, the obtaining module 510 is further configured to: obtain a plurality of image samples, where each of the plurality of image samples includes at least one graphic entity and annotation information of the at least one graphic entity; and train the entity recognition model by using the plurality of image samples.

According to some implementations of the present disclosure, the obtaining module 510 is further configured to: save a region of the first image corresponding to each of the plurality of second electrical elements as a second image to obtain a set of second images; and update the entity recognition model by using the set of second images.

According to some implementations of the present disclosure, the determination module 530 is further configured to: determine, for a first electrical element of the one or more first electrical elements, a material item for the first electrical element based on the first name information and the first location of the first electrical element; and generate the bill of materials based on at least material items determined respectively for the one or more first electrical elements.

FIG. 6 illustrates a block diagram of an electronic device 600 in which one or more embodiments of the present disclosure may be implemented. For example, the electronic device 600 may be configured to implement the electronic device 110 shown in FIG. 1. It should be understood that the electronic device 600 illustrated in FIG. 6 is merely illustrative and should not constitute any limitation on the functionality and scope of the embodiments described herein.

As shown in FIG. 6, the electronic device 600 is in the form of a general-purpose electronic device. Components of the electronic device 600 may include, but are not limited to, one or more processors 610 or processing units, a memory 620, a storage device 630, one or more communication units 640, one or more input devices 650, and one or more output devices 660. The processing unit may be an actual or virtual processor and capable of performing various processes according to programs stored in the memory 620. In a multiprocessor system, a plurality of processing units executes computer-executable instructions in parallel to improve the parallel processing capability of the electronic device 600.

The electronic device 600 generally includes a plurality of computer storage media. Such media may be any available media accessible to the electronic device 600, including, but not limited to, volatile and non-volatile media, removable and non-removable media. The memory 620 may be volatile memory (e.g., a register, a cache, random access memory (RAM)), non-volatile memory (e.g., read-only memory (ROM), electrically erasable programmable read-only memory (EEPROM), flash memory), or some combination thereof. The storage device 630 may be a removable or non-removable medium and may include a machine-readable medium, such as a flash drive, a magnetic disk, or any other medium, which may be capable of storing information and/or data (e.g., training data for training) and may be accessed within the electronic device 600.

The electronic device 600 may further include additional removable/non-removable, volatile/non-volatile storage media. Although not shown in FIG. 6, a disk drive for reading from or writing into a removable, nonvolatile magnetic disk (e.g., a "floppy disk") and an optical disk drive for reading from or writing into a removable, nonvolatile optical disk may be provided. In these cases, each drive may be connected to a bus (not shown) by one or more data medium interfaces. The memory 620 may include a computer program product 625 having one or more program modules configured to perform various methods or actions of various embodiments of the present disclosure.

The communication unit 640 is configured to communicate with other electronic devices through communication medium/media. Additionally, the functionality of components of the electronic device 600 may be implemented in a single computing cluster or a plurality of computing machines capable of communicating through communication connection. Thus, the electronic device 600 may operate in a networked environment using logical connections with one or more other servers, a network personal computer (PC), or another network node.

The input device 650 may be one or more input devices, such as a mouse, a keyboard, a trackball, or the like. The output device 660 may be one or more output devices, such as a display, a speaker, a printer, or the like. The electronic device 600 may also communicate with one or more external devices (not shown) through the communication unit 640 as needed, and the external device such as a storage device, a display device, etc., communicates with one or more devices that enable a user to interact with the electronic device 600, or communicates with any device (e.g., a network card, a modem, etc.) that enables the electronic device 600 to communicate with one or more other electronic devices. Such communication may be performed via an input/output (I/O) interface (not shown).

According to example implementations of the present disclosure, there is provided a computer-readable storage medium having one or more computer instructions stored thereon, where one or more computer instructions are executed by a processor to implement the method described above.

Aspects of the present disclosure are described herein with reference to flowcharts and/or block diagrams of methods, apparatuses (systems), and computer program products implemented in accordance with the present disclosure. It should be understood that each block of the flowchart(s) and/or block diagram(s), and combination(s) of blocks in the flowchart(s) and/or block diagram(s), may be implemented by computer readable program instructions.

These computer-readable program instructions may be provided to a processing unit of a general purpose computer, special purpose computer, or other programmable data processing apparatus to produce a machine, such that the instructions, when executed by a processing unit of a computer or other programmable data processing apparatus, produce means to implement the functions/acts specified in the one or more blocks in the flowchart(s) and/or block diagram(s). These computer-readable program instructions may also be stored in a computer-readable storage medium, and these instructions cause the computer, programmable data processing apparatus, and/or other devices to function in a particular manner, such that the computer-readable medium storing instructions includes an article of manufacture including instructions to implement aspects of the functions/acts specified in the one or more blocks in the flowchart(s) and/or block diagram(s).

The computer-readable program instructions may also be loaded onto a computer, other programmable data processing apparatus, or other apparatus, such that a series of operational steps are performed on a computer, other programmable data processing apparatus, or other apparatus to produce a computer-implemented process such that the instructions executed on a computer, other programmable data processing apparatus, or other apparatus implement the functions/acts specified in the one or more blocks in the flowchart(s) and/or block diagram(s).

The flowchart(s) and block diagram(s) in the drawings show architecture, functionality, and operation of possible implementations of systems, methods, and computer program products according to various implementations of the present disclosure. In this regard, each block in the flowchart(s) or block diagram(s) may represent a module, program segment, or portion of an instruction that includes one or more executable instructions for implementing the specified logical function. In some alternative implementations, the functions noted in the block(s) may also occur in a different order than noted in the figures. For example, two consecutive blocks may actually be performed substantially in parallel, which may sometimes be performed in the reverse order, depending on the functionality involved. It is also noted that each block in the block diagram(s) and/or flowchart(s), as well as combination(s) of blocks in the block diagram(s) and/or flowchart(s), may be implemented with a dedicated hardware-based system that performs the specified functions or actions, or may be implemented in a combination of dedicated hardware and computer instructions.

Various implementations of the present disclosure have been described above, which are illustrative, not exhaustive, and are not limited to the implementations disclosed. Many modifications and variations will be apparent to those of ordinary skill in the art without departing from the scope of the various implementations illustrated. The selection of the terms used herein is intended to best explain the principles of the implementations, practical applications, or improvements to techniques in the marketplace, or to enable others of ordinary skill in the art to understand the implementations disclosed herein.

## Claims

1. A method (200) of recognizing an electrical element, the method comprising:
obtaining (210) graphic data of a graphic file to be recognized, the graphic file indicating a layout of electrical elements of an electrical system, and the graphic data comprising respective data indicating a plurality of graphic entities of the layout of electrical elements;
recognizing (220) one or more block graphic entities from the graphic data based on the respective data of the plurality of graphic entities; and
determining (230), based on respective data of the one or more block graphic entities, one or more first electrical elements of the electrical system respectively corresponding to the one or more block graphic entities and respective first locations of the one or more first electrical elements in the electrical system.

2. The method (200) of claim 1, comprising:
generating a first image based on data, in the graphic data, other than respective data of the one or more block graphic entities; and
determining, based on the first image, one or more second electrical elements of the electrical system and respective second locations of the one or more second electrical elements in the electrical system by using an entity recognition model.

3. The method (200) of claim 2, wherein the graphic data comprises text annotation data, and the method comprises:
marking a visibility attribute of the text annotation data as invisible before generating the first image.

4. The method (200) of claim 2 or claim 3, wherein generating the first image comprises:
marking a visibility attribute of the respective data of the one or more block graphic entities as invisible; and
generating the first image based on remaining visible data in the graphic data.

5. The method (200) of any of claims 2 to 4, comprising:
obtaining a plurality of image samples, wherein each of the plurality of image samples comprises at least one graphic entity and annotation information of the at least one graphic entity; and
training the entity recognition model by using the plurality of image samples.

6. The method (200) of claim 5, comprising:
saving a region of the first image corresponding to each of the plurality of second electrical elements as a second image to obtain a set of second images; and
updating the entity recognition model by using the set of second images.

7. The method (200) of any of claims 1 to 6, comprising:
generating a bill of materials for the electrical system based at least on respective first name information and the respective first locations of the one or more first electrical elements.

8. The method (200) of claim 7, wherein generating the bill of materials for the electrical system comprises:
determining, for a first electrical element of the one or more first electrical elements, a material item for the first electrical element based on the first name information and the first location of the first electrical element; and
generating the bill of materials based on at least material items determined respectively for the one or more first electrical elements.

9. An apparatus (500) for recognizing an electrical element, the apparatus (500) comprising:
an obtaining module (510) configured to obtain graphic data of a graphic file to be recognized, the graphic file indicating a layout of electrical elements of an electrical system, and the graphic data comprising respective data indicating a plurality of graphic entities of the layout of electric elements;
a recognition module (520) configured to recognize one or more block graphic entities from the graphic data based on the respective data of the plurality of graphic entities; and
a determination module (530) configured to determine, based on the respective data of the one or more block graphic entities, one or more first electrical elements of the electrical system respectively corresponding to the one or more block graphic entities and respective first locations of the one or more first electrical elements in the electrical system.

10. An electronic device (600), the electronic device (600)comprising:
at least one processing unit (610); and
at least one memory (620) coupled to the at least one processing unit(610) and storing instructions for execution by the at least one processing unit(610), the instructions, when executed by the at least one processing unit(610), causing the electronic device (600) to perform the method (200) of any of claims 1 to 8.

11. A computer-readable storage medium having a computer program stored thereon, wherein the computer program, when executed by a processor, causes the processor to implement the method (200) of any of claims 1 to 8.

12. A computer program, wherein the computer program, when executed by a processor, implements the method (200) of any of claims 1 to 8.
